(19) Europäisches Patentamt / European Patent Office / Office européen des brevets

(11) **EP 3 886 191 A1**

(12) **EUROPEAN PATENT APPLICATION**
published in accordance with Art. 153(4) EPC

(43) Date of publication:
**29.09.2021 Bulletin 2021/39**

(51) Int Cl.:
**H01L 51/44** *(2006.01)*　　**H01L 31/0352** *(2006.01)*

(21) Application number: **18940577.2**

(22) Date of filing: **19.11.2018**

(86) International application number:
**PCT/JP2018/042655**

(87) International publication number:
**WO 2020/105087 (28.05.2020 Gazette 2020/22)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Kao Corporation**
**Chuo-ku,**
**Tokyo 103-8210 (JP)**

(72) Inventor: **HOSOKAWA, Hiroji**
**Wakayama-shi, Wakayama 640-8580 (JP)**

(74) Representative: **Hoffmann Eitle**
**Patent- und Rechtsanwälte PartmbB**
**Arabellastraße 30**
**81925 München (DE)**

(54) **LIGHT ABSORPTION LAYER, PHOTOELECTRIC CONVERSION ELEMENT, AND SOLAR CELL**

(57) The present invention pertains to a light absorption layer for forming a photoelectric conversion element and a solar cell having an excellent photoelectric conversion efficiency, and a photoelectric conversion element and a solar cell having the light absorption layer. This light absorption layer contains a perovskite compound and quantum dots, and the quantum dots have a circularity of 0.50 to 0.92. The present invention is a light absorption layer, a photoelectric conversion element, and a solar cell containing a perovskite compound and quantum dots, wherein the particle shape of the quantum dots is controlled, the surface of the quantum dots is covered by a compound having a specific energy level, or the above features are combined, whereby it is made possible to obtain a light absorption layer, a photoelectric conversion element, and a solar cell having an excellent photoelectric conversion efficiency.

Fig.1

**Description**

TECHNICAL FIELD

The present invention relates to a light absorption layer, a photoelectric conversion element having the light absorption layer, and a solar cell having the photoelectric conversion element.

BACKGROUND ART

A photoelectric conversion element that converts light energy into electric energy is used for solar cells, optical sensors, copying machines, and the like. In particular, from the viewpoint of environmental and energy problems, photoelectric conversion elements (solar cells) utilizing sunlight that is an inexhaustible clean energy attract attention.

Since general silicon solar cells utilize ultra-high purity silicon and are manufactured by "dry process" such as epitaxial crystal growth under high vacuum, it is not possible to expect a large cost reduction. Therefore, a solar cell manufactured by a "wet process" such as a coating process is expected as a low-cost next generation solar cell.

A quantum dot solar cell is a next-generation solar cell that can be manufactured by the "wet process". The quantum dot is an inorganic nanoparticle having a particle size of about 20 nm or less and exhibits physical properties different from those of bulk bodies due to the expression of quantum size effect. For example, it is known that the band gap energy increases (shortening of the absorption wavelength) as the particle size of quantum dots decreases, and lead sulfide (PbS) quantum dots having a particle size of about 3 nm and a band gap energy of about 1.2 eV have been reported for use in quantum dot solar cells (ACS Nano 2014, 8, 614-622).

In addition, there is a perovskite solar cell as the most promising candidate for the next generation solar cell, which has been recently reported to show a rapid increase in photoelectric conversion efficiency. This perovskite solar cell is provided with a photoelectric conversion element using a perovskite compound ($CH_3NH_3PbI_3$) composed of a cation such as methyl ammonium and a halogenated metal salt such as lead iodide ($PbI_2$) for the light absorption layer (J. Am. Chem. Soc. 2009, 131, 6050-6051). It is known that the chemical and physical properties of the perovskite compound change depending on the composition of the cationic species, halogen element, metal element and the like.

In addition, a perovskite solar cell in which PbS quantum dots that absorb near-infrared light are compounded in order to provide photoelectric conversion in the near-infrared light region where a perovskite compound does not absorb light has been reported (WO2018/025445). Furthermore, an intermediate band-type solar cell having a light absorption layer in which PbS quantum dots are dispersed in a matrix of a perovskite compound has been reported (JP-B-6343406).

The present invention relates to a light absorption layer for forming a photoelectric conversion element and a solar cell excellent in photoelectric conversion efficiency, and a photoelectric conversion element and a solar cell each having the light absorption layer.

The present inventors have found that when a perovskite compound is compounded with even a small amount of quantum dots, the photoelectric conversion efficiency is unfortunately lowered.

Also, the present inventors have found that in the case of compounding quantum dots with a perovskite compound, the decrease in photoelectric conversion efficiency can be suppressed by controlling the particle shape of the quantum dots, covering the surface of the quantum dots with a compound having a specific energy level, or combining these features.

The present invention is related to a light absorption layer, comprising a perovskite compound and quantum dots, wherein the quantum dots have a circularity of 0.50 to 0.92.

Also, the present invention is related to a light absorption layer, comprising a perovskite compound, and quantum dots containing a compound which has a lower end of a conduction band at a more negative energy level than an energy level of a lower end of a conduction band of the perovskite compound, and/or has an upper end of a valence band at a more positive energy level than an energy level of an upper end of a valence band of the perovskite compound.

Although it is not clear why the decrease in photoelectric conversion efficiency can be suppressed by using quantum dots having a specific circularity, it is presumed that the change in viscosity of a dispersion liquid (coating liquid) containing the quantum dots improves the film quality (coverage) of the obtained light absorption layer so that the heat deactivation of a carrier on the surface of the perovskite compound is suppressed.

In addition, although it is not clear why the decrease in photoelectric conversion efficiency can be suppressed by covering the surface of the quantum dots with a compound having a specific energy level, it is presumed that the presence of the compound having a specific energy level at the interface between the perovskite compound and the quantum dots changes the energy level at that interface so that the heat deactivation of a carrier is suppressed.

According to the present invention, a light absorption layer, a photoelectric conversion element, and a solar cell having an excellent photoelectric conversion efficiency can be obtained by, in the light absorption layer, photoelectric conversion element, and solar cell containing a perovskite compound and quantum dots, controlling the particle shape of the quantum dots, covering the surface of the quantum dots with a compound having a specific energy level, or combining these operations.

BRIEF DESCRIPTION OF THE DRAWINGS

Fig. 1 is a schematic cross-sectional view showing an example of the structure of a photoelectric conversion element of the present invention.
Fig. 2 is a STEM (Z contrast) image of quantum dots used in Example 1.

MODE FOR CARRYING OUT THE INVENTION

<Light Absorption Layer>

The light absorption layer of the present invention contains, as light absorbing agents, a perovskite compound and quantum dots. The light absorption layer of the present invention may contain other light absorbing agents other than those mentioned above as long as the effect of the present invention is not impaired.

The perovskite compound is a compound having a perovskite type crystal structure and known ones can be used without any particular limitation, and from the viewpoint of improving durability (moisture resistance) and photoelectric conversion efficiency, a perovskite compound having a band gap energy of 1.5 eV or more and 4.0 eV or less is preferably used. The perovskite compound may be used singly or in combination of two or more kinds having different band gap energies.

From the viewpoint of improving the photoelectric conversion efficiency (voltage), the band gap energy of the perovskite compound is preferably 2.0 eV or more, more preferably 2.1 eV or more, still more preferably 2.2 eV or more, and from the viewpoint of improving the photoelectric conversion efficiency (current), the band gap energy of the perovskite compound is preferably 3.6 eV or less, more preferably 3.0 eV or less, still more preferably 2.4 eV or less. The band gap energies of the perovskite compound and the quantum dot can be determined from the absorption spectrum measured at 25°C by the method described in Examples described later. The wavelength corresponding to the band gap energy determined from the absorption spectrum is called an absorption edge wavelength.

The energy level at the lower end of the conduction band of the perovskite compound is preferably 2.0 eV vs. vacuum or more, more preferably 3.0 eV vs. vacuum or more, still more preferably 3.3 eV vs. vacuum or more, from the viewpoint of improving the electron extraction efficiency of perovskite and improving the photoelectric conversion efficiency, and preferably 5.0 eV vs. vacuum or less, more preferably 4.0 eV vs. vacuum or less, still more preferably 3.5 eV. vs. vacuum or less, from the viewpoint of improving the voltage and improving the photoelectric conversion efficiency.

The energy level at the upper end of the valence band of the perovskite compound is preferably 4.0 eV vs. vacuum or more, more preferably 5.0 eV vs. vacuum or more, still more preferably 5.6 eV vs. vacuum or more, from the viewpoint of improving the voltage and improving the photoelectric conversion efficiency, and preferably 7.0 eV vs. vacuum or less, more preferably 6.0 eV vs. vacuum or less, still more preferably 5.8 eV vs. vacuum or less, from the viewpoint of improving the hole extraction efficiency of perovskite and improving the photoelectric conversion efficiency.

The perovskite compound is preferable to use one or more kinds selected from a compound represented by the following general formula (1) and a compound represented by the following general formula (2). From the viewpoint of achieving both durability and photoelectric conversion efficiency, a compound represented by the following general formula (1) is more preferable.

$$RMX_3 \qquad (1)$$

(R is a monovalent cation, M is a divalent metal cation, and X is a halogen anion.)

$$R^1R^2R^3_{n-1}M_nX_{3n+1} \qquad (2)$$

($R^1$, $R^2$ and $R^3$ are each independently a monovalent cation, M is a divalent metal cation, X is a halogen anion, and n is an integer of 1 to 10.)

The R is a monovalent cation, for example, a cation of the group 1 of the periodic table and includes an organic cation. Examples of the cation of the group 1 of the periodic table include $Li^+$, $Na^+$, $K^+$, and $Cs^+$. Examples of the organic cation include an ammonium ion which may have a substituent and a phosphonium ion which may have a substituent. There is no particular limitation on the substituent. Examples of the optionally substituted ammonium ion include an alkylammonium ion, a formamidinium ion and an arylammonium ion, and from the viewpoint of achieving both durability and photoelectric conversion efficiency, the optionally substituted ammonium ion is preferably one or more kinds selected from an alkyl ammonium ion and a formamidinium ion, more preferably one or more kinds selected from a monoalkylammonium ion and a formamidinium ion, still more preferably one or more kinds selected from a methylammonium ion, an ethylammonium ion, a butylammonium ion and a formamidinium ion, and even still more preferably a methylammonium ion.

Each of $R^1$, $R^2$, and $R^3$ mentioned above is independently a monovalent cation, and any or all of $R^1$, $R^2$, and $R^3$ may be the same. For example, examples of the monovalent cation include a cation of the group 1 of the periodic table and an organic cation. Examples of the cation of the group 1 of the periodic table include $Li^+$, $Na^+$, $K^+$, and $Cs^+$. Examples of the organic cation include an ammonium ion which may have a substituent and a phosphonium ion which may have a substituent. There is no particular restriction on the substituent. Examples of the optionally substituted ammonium ion include an alkylammonium ion, a formamidinium ion and an arylammonium ion, and from the viewpoint of achieving both durability and photoelectric conversion efficiency, the optionally substituted ammonium ion is preferably one or more kinds selected from an alkyl ammonium ion and a formamidinium ion, more preferably a monoalkylammonium ion, still more preferably one or more kinds selected from a methylammonium ion, an ethylammonium ion, a butylammonium ion, a hexylammonium ion, an octylammonium ion, a decylammonium ion, a dodecyl ammonium ion, a tetradecyl ammonium ion, a hexadecyl ammonium ion, and an octadecyl ammonium ion.

The n is an integer of 1 to 10 and from the viewpoint of achieving both durability and photoelectric conversion efficiency, n is preferably 1 to 4.

The M is a divalent metal cation and includes, for example, $Pb^{2+}$, $Sn^{2+}$, $Hg^{2+}$, $Cd^{2+}$, $Zn^{2+}$, $Mn^{2+}$, $Cu^{2+}$, $Ni^{2+}$, $Fe^{2+}$, $Co^{2+}$, $Pd^{2+}$, $Ge^{2+}$, $Y^{2+}$, and $Eu^{2+}$. From the viewpoint of excellent durability (moisture resistance) and photoelectric conversion efficiency, the M is preferably $Pb^{2+}$, $Sn^{2+}$, or $Ge^{2+}$, more preferably $Pb^{2+}$ or $Sn^{2+}$, still more preferably $Pb^{2+}$.

The X is a halogen anion, and examples thereof include a fluorine anion, a chlorine anion, a bromine anion, and an iodine anion. In order to obtain a perovskite compound having a desired band gap energy, the X is preferably a fluorine anion, a chlorine anion or a bromine anion, more preferably a chlorine anion or a bromine anion, still more preferably a bromine anion.

Examples of the compound represented by the general formula (1) having a band gap energy of 1.5 eV or more and 4.0 eV or less include $CH_3NH_3PbCl_3$, $CH_3NH_3PbBr_3$, $CH_3NH_3PbI_3$, $CH_3NH_3PbBrI_2$, $CH_3NH_3PbBr_2I$, $CH_3NH_3SnCl_3$, $CH_3NH_3SnBr_3$, $CH_3NH_3SnI_3$, $CH(=NH)NH_3PbCl_3$, $CH(=NH)NH_3PbBr_3$, and $CH(=NH)NH_3PbI_3$. Among these, from the viewpoint of achieving both durability and photoelectric conversion efficiency at the same time, $CH_3NH_3PbBr_3$ and $CH(=NH)NH_3PbBr_3$ are preferable and $CH_3NH_3PbBr_3$ is more preferable.

Examples of the compound represented by the general formula (2) having a band gap energy of 1.5 eV or more and 4.0 eV or less include $(C_4H_9NH_3)_2PbI_4$, $(C_6H_{13}NH_3)_2PbI_4$, $(C_8H_{17}NH_3)_2PbI_4$, $(C_{10}H_{21}NH_3)_2PbI_4$, $(C_{12}H_{25}NH_3)_2PbI_4$, $(C_4H_9NH_3)_2(CH_3NH_3)Pb_2I_7$, $(C_6H_{13}NH_3)_2(CH_3NH_3)Pb_2I_7$, $(C_8H_{17}NH_3)_2(CH_3NH_3)Pb_2I_7$, $(C_{10}H_{21}NH_3)_2(CH_3NH_3)Pb_2I_7$, $(C_{12}H_{25}NH_3)_2(CH_3NH_3)Pb_2I_7$, $(C_4H_9NH_3)_2(CH_3NH_3)_2Pb_3I_{10}$, $(C_6H_{13}NH_3)_2(CH_3NH_3)_2Pb_3I_{10}$, $(C_8H_{17}NH_3)_2(CH_3NH_3)_2Pb_3I_{10}$, $(C_{10}H_{21}NH_3)_2(CH_3NH_3)_2Pb_3I_{10}$, $(C_{12}H_{25}NH_3)_2(CH_3NH_3)_2Pb_3I_{10}$, $(C_4H_9NH_3)_2PbBr_4$, $(C_6H_{13}NH_3)_2PbBr_4$, $(C_8H_{17}NH_3)_2PbBr_4$, $(C_{10}H_{21}NH_3)_2PbBr_4$, $(C_4H_9NH_3)_2(CH_3NH_3)Pb_2Br_7$, $(C_6H_{13}NH_3)_2(CH_3NH_3)Pb_2Br_7$, $(C_8H_{17}NH_3)_2(CH_3NH_3)Pb_2Br_7$, $(C_{10}H_{21}NH_3)_2(CH_3NH_3)Pb_2Br_7$, $(C_{12}H_{25}NH_3)_2(CH_3NH_3)Pb_2Br_7$, $(C_4H_9NH_3)_2(CH_3NH_3)_2Pb_3Br_{10}$, $(C_6H_{13}NH_3)_2(CH_3NH_3)_2Pb_3Br_{10}$, $(C_8H_{17}NH_3)_2(CH_3NH_3)_2Pb_3Br_{10}$, $(C_{10}H_{21}NH_3)_2(CH_3NH_3)_2Pb_3Br_{10}$, $(C_{12}H_{25}NH_3)_2(CH_3NH_3)_2Pb_3Br_{10}$, $(C_4H_9NH_3)_2(CH_3NH_3)_2Pb_3Cl_{10}$, $(C_6H_{13}NH_3)_2(CH_3NH_3)_2Pb_3Cl_{10}$, $(C_8H_{17}NH_3)_2(CH_3NH_3)_2Pb_3Cl_{10}$, $(C_{10}H_{21}NH_3)_2(CH_3NH_3)_2Pb_3Cl_{10}$, and $(C_{12}H_{25}NH_3)_2(CH_3NH_3)_2Pb_3Cl_{10}$.

The perovskite compound can be produced, for example, from a perovskite compound precursor as described later. As a precursor of the perovskite compound, for example, in the case where the perovskite compound is a compound represented by the general formula (1), a combination of a compound represented by $MX_2$ and a compound represented by RX can be mentioned. Also, in the case where the perovskite compound is a compound represented by the general formula (2), a combination of a compound represented by $MX_2$ with one or more kinds selected from a compound represented by $R^1X$, a compound represented by $R^2X$, and a compound represented by $R^3X$ can be mentioned.

The perovskite compound in the light absorption layer can be identified by the conventional methods such as element analysis, infrared (IR) spectrum, Raman spectrum, nuclear magnetic resonance (NMR) spectrum, X-ray diffraction pattern, absorption spectrum, emission spectrum, electron microscope observation, and electron beam diffraction.

The quantum dot is an inorganic nanoparticle having a crystal structure having a particle size of about 20 nm or less, and exhibits physical properties different from those of bulk bodies due to the expression of quantum size effect.

In the present invention, quantum dots having a circularity of 0.50 to 0.92 are used from the viewpoint of improving the film forming property (film uniformity) of the light absorption layer and suppressing the decrease in photoelectric conversion efficiency. From the above viewpoint, the viewpoint of ease of manufacture, and the viewpoint of economic efficiency, the circularity of quantum dots is preferably 0.60 or more, more preferably 0.65 or more, and preferably 0.90 or less, more preferably 0.80 or less. The circularity of quantum dots can be calculated by the method described in Examples below.

From the viewpoint of complementing the band gap energy which the perovskite compound does not have and improving the photoelectric conversion efficiency of the near-infrared light region, the quantum dot having a band gap equal to or more than 0.2 eV and less than the band gap energy of the perovskite compound is preferably used. The quantum dots may be used singly or in combination of two or more kinds having different band gap energies. When two or more kinds of perovskite compounds having different band gap energies are used, "the band gap energy less than the band gap energy of the perovskite compound", which is the upper limit of the band gap energy of the quantum dot, means a band gap energy less than the maximum value of the band gap energy of two or more kinds of perovskite compounds. Hereinafter, unless otherwise specified, preferred embodiments of quantum dots are preferred embodiments common to the light absorption layer and its raw materials.

From the viewpoint of improving the photoelectric conversion efficiency (voltage), the band gap energy of the quantum dot (or core-shell quantum dot described below) is preferably 0.5 eV or more, more preferably 0.6 eV or more, still more preferably 0.7 eV or more, even still more preferably 0.8 eV or more, and from the viewpoint of improving the photoelectric conversion efficiency (current), the band gap energy of the quantum dot is preferably 1.0 eV or less, more preferably 0.95 eV or less, still more preferably 0.9 eV or less, even still more preferably 0.85 eV or less.

Regarding the quantum dots, if the particle size and kind of quantum dots are determined by electron microscopic observation, electron beam diffraction, X-ray diffraction pattern, etc., it is also possible to calculate the band gap energy from the correlation between the particle size and the band gap energy (see, for example, ACS Nano 2014, 8, 6363-6371).

The difference between the band gap energy of the perovskite compound and the band gap energy of the quantum dot is preferably 1.0 eV or more, more preferably 1.4 eV or more, still more preferably 1.45 eV or more, and preferably 2.0 eV or less, more preferably 1.7 eV or less, still more preferably 1.5 eV or less, from the viewpoint of improving photoelectric conversion efficiency.

The emission peak energy of quantum dot is preferably 0.2 eV or more, more preferably 0.4 eV or more, still more preferably 0.6 eV or more, even more preferably 0.8 eV or more when the light absorption layer is excited with light having a wavelength of 800 nm (energy 1.55 eV), from the viewpoint of improving the photoelectric conversion efficiency (voltage), and preferably 1.4 eV or less, more preferably 1.2 eV or less, still more preferably 1.0 eV or less, even more preferably 0.95 eV or less, from the viewpoint of improving the photoelectric conversion efficiency (current).

The difference between the emission peak energy of quantum dot and the bandgap energy of perovskite compound is preferably 0.4 eV or more, more preferably 0.8 eV or more, still more preferably 1.2 eV or more, even more preferably 1.4 eV or more, and preferably 3.4 eV or less, more preferably 2.5 eV or less, still more preferably 2.0 eV or less, even more preferably 1.5 eV or less, from the viewpoint of improving the photoelectric conversion efficiency.

The difference between the emission peak energy of quantum dot and the bandgap energy of quantum dot is preferably 0.01 eV or more, more preferably 0.03 eV or more, still more preferably 0.05 eV or more, and preferably 0.3 eV or less, more preferably 0.2 eV or less, still more preferably 0.1 eV or less, from the viewpoint of improving the photoelectric conversion efficiency.

The emission peak energy of quantum dot can be determined as, for example, a peak wavelength (peak energy) of the emission spectrum when the light absorption layer is excited by light having a wavelength of 800 nm (energy 1.55 eV) as described in the following Examples.

From the viewpoint of improving stability and photoelectric conversion efficiency, the particle size of the quantum dot is preferably 1 nm or more, more preferably 2 nm or more, still more preferably 3 nm or more, and from the viewpoint of improving film formability and photoelectric conversion efficiency, the particle size of the quantum dot is preferably 20 nm or less, more preferably 10 nm or less, still more preferably 5 nm or less. The particle size of the quantum dot can be measured by a conventional method such as crystallite diameter analysis of XRD (X-ray diffraction) or transmission electron microscope observation.

Examples of the quantum dots having such a band gap energy include metal oxides, metal chalcogenides (such as sulfides, selenides, and tellurides), specifically $PbS$, $PbSe$, $PbTe$, $CdS$, $CdSe$, $CdTe$, $Sb_2S_3$, $Bi_2S_3$, $Ag_2S$, $Ag_2Se$, $Ag_2Te$, $Au_2S$, $Au_2Se$, $Au_2Te$, $Cu_2S$, $Cu_2Se$, $Cu_2Te$, $Fe_2S$, $Fe_2Se$, $Fe_2Te$, $In_2S_3$, $SnS$, $SnSe$, $SnTe$, $CuInS_2$, $CuInSe_2$, $CuInTe_2$, $EuS$, $EuSe$, and $EuTe$. From the viewpoint of excellent durability (oxidation resistance) and photoelectric conversion efficiency, the quantum dot preferably contains Pb element, more preferably $PbS$ or $PbSe$, still more preferably $PbS$. In order to increase the interaction between the perovskite compound and the quantum dot, the metal constituting the perovskite compound and the metal constituting the quantum dot are preferably the same metal.

From the viewpoints of dispersibility in the light absorption layer and in the dispersion, ease of production, cost, excellent performance expression, etc., the quantum dots may contain one or more kinds selected from an organic ligand and a halogen element.

Examples of the organic ligand include a carboxyl group-containing compound, an amino group-containing compound, a thiol group-containing compound, and a phosphino group-containing compound.

Examples of the carboxyl group-containing compound include oleic acid, stearic acid, palmitic acid, myristic acid, lauric acid, capric acid, and the like.

Examples of the amino group-containing compound include oleylamine, stearylamine, palmitylamine, myristylamine, laurylamine, caprylamine, octylamine, hexylamine, butylamine and the like.

Examples of the thiol group-containing compound include ethanethiol, ethanedithiol, benzenethiol, benzenedithiol, decanethiol, decanedithiol, mercaptopropionic acid, and the like.

Examples of the phosphino group-containing compound include trioctylphosphine, tributylphosphine, and the like.

The organic ligand is preferably a carboxy group-containing compound or an amino group-containing compound, more preferably a carboxy group-containing compound, still more preferably a long chain fatty acid, even still more preferably oleic acid, from the viewpoints of ease of production, dispersion stability, versatility, cost, and excellent performance expression of the quantum dot.

In the case where the quantum dot preferably contains an organic ligand, the molar ratio of the organic ligand to the metal element (In the case where the quantum dot is a core-shell quantum dot described below, the metal element means a metal element constituting a core.) constituting the quantum dot in the quantum dot used as a raw material in manufacturing the light absorption layer is preferably 0.1 or more, more preferably 0.3 or more, still more preferably 0.5 or more, from the viewpoint of promoting ligand exchange between the organic ligand and the precursor of the perovskite compound during production of the light absorption layer, and is preferably 2.0 or less, more preferably 1.5 or less, still more preferably 1.3 or less, from the viewpoint of improving the dispersibility of the quantum dots in the light absorption layer or in the dispersion.

The quantum dots of the light absorption layer can be identified, for example, by element analysis, infrared (IR) spectrum, Raman spectrum, nuclear magnetic resonance (NMR) spectrum, X-ray diffraction pattern, absorption spectrum, emission spectrum, small angle X-ray scattering, electron microscopic observation, electron beam diffraction, and the like.

A preferable combination of the perovskite compound and the quantum dot is preferably a combination of compounds containing the same metal element from the viewpoint of achieving both durability and photoelectric conversion efficiency, for example, a combination of $CH_3NH_3PbBr_3$ and PbS, a combination of $CH_3NH_3PbBr_3$ and PbSe, a combination of $CH(=NH)NH_3PbBr_3$ and PbS, and a combination of $CH(=NH)NH_3PbBr_3$ and PbSe, and more preferably a combination of $CH_3NH_3PbBr_3$ and PbS.

The quantum dots having a circularity of 0.50 to 0.92 can be obtained by, for example, a method for changing the crystal growth rate of quantum dot by rapidly changing the reaction temperature during crystal growth, the rate of addition of a raw material, or the like, a method for preferentially crystal-growing only a specific crystal plane by coexisting a ligand that specifically interacts only with a specific crystal plane of quantum dot during crystal growth, and a method for forming a quantum dot into a core-shell structure by attaching and bonding a compound different from a quantum dot core to the surface of the quantum dot core, preferably a method for forming a quantum dot into a core-shell structure.

Examples of the compound constituting the core of the quantum dot having a core-shell structure (hereinafter referred to as core-shell quantum dot) include, similar to the material for the quantum dot, metal oxides, metal chalcogenides (for example, sulfides, selenides, and tellurides), specifically PbS, PbSe, PbTe, CdS, CdSe, CdTe, $Sb_2S_3$, $Bi_2S_3$, $Ag_2S$, $Ag_2Se$, $Ag_2Te$, $Au_2S$, $Au_2Se$, $Au_2Te$, $Cu_2S$, $Cu_2Se$, $Cu_2Te$, $Fe_2S$, $Fe_2Se$, $Fe_2Te$, $In_2S_3$, SnS, SnSe, SnTe, $CuInS_2$, $CuInSe_2$, $CuInTe_2$, EuS, EuSe, and EuTe. The compound constituting the core of the core-shell quantum dot preferably includes a Pb element, more preferably includes PbS or PbSe, still more preferably includes PbS, from the viewpoint of excellent durability (oxidation resistance) and photoelectric conversion efficiency. In addition, in order to increase the interaction between the perovskite compound and the core-shell quantum dot, it is preferable that the metal element constituting the perovskite compound and the metal element constituting the core of the core-shell quantum dot be the same as each other.

The particle size of the core of the core-shell quantum dot is preferably 1 nm or more, more preferably 2 nm or more, still more preferably 2.5 nm or more, from the viewpoint of improving the stability and photoelectric conversion efficiency, and preferably 20 nm or less, more preferably 10 nm or less, still more preferably 5 nm or less, from the viewpoint of improving the film forming property and photoelectric conversion efficiency. The particle size of the core of the core-shell quantum dot can be measured by a conventional method such as X-ray diffraction (XRD) crystallite size analysis or transmission electron microscope observation.

The bandgap energy of the core of the core-shell quantum dot is preferably 0.5 eV or more, more preferably 0.6 eV or more, still more preferably 0.7 eV or more, even more preferably 0.8 eV or more, from the viewpoint of improving the photoelectric conversion efficiency (voltage), and preferably 1.0 eV or less, more preferably 0.95 eV or less, still more preferably 0.9 eV or less, even more preferably 0.85 eV or less, from the viewpoint of improving the photoelectric conversion efficiency (current).

The core of the core-shell quantum dot contains a compound which preferably has a lower end of the conduction band at a more positive energy level than the energy level of the lower end of the conduction band of the perovskite compound, and/or has an upper end of the valence band at a more negative energy level than the energy level of the upper end of the valence band of the perovskite compound, from the viewpoint of forming an intermediate band in the light absorption layer, and improving the quantum efficiency of two-step light absorption. From the above viewpoint, the compound has a lower end of the conduction band at a positive energy level of preferably 0.1 eV or more, more preferably 0.3 eV or more, still more preferably 0.5 eV or more, and preferably 2.0 eV or less, more preferably 0.8 eV or less, still more preferably 0.65 eV or less, with respect to the energy level of the lower end of the conduction band of the perovskite compound. In addition, from the above viewpoint, the compound has an upper end of the valence band at a negative energy level of preferably 0.1 eV or more, more preferably 0.3 eV or more, and preferably 1.0 eV or less, more preferably 0.6 eV or less, with respect to the energy level of the upper end of the valence band of the perovskite compound.

Examples of the compound constituting the shell of the core-shell quantum dot include the compound constituting the core of the core-shell quantum dot, the perovskite compound, ZnS, ZnSe, InGaAs, InGaN, GaSb, and GaP. The compound constituting the shell of the core-shell quantum dot preferably includes a metal element different from the metal element constituting the core of the core-shell quantum dot, more preferably includes a Zn element, still more preferably includes ZnS and/or ZnSe, even more preferably includes ZnS, from the viewpoint of suppressing the heat deactivation of a carrier on the surface of the perovskite compound and improving the photoelectric conversion efficiency. In addition, from the viewpoint of suppressing the heat deactivation of a carrier on the surface of the perovskite compound and improving the photoelectric conversion efficiency, it is preferable that the metal element constituting the perovskite compound and the metal element constituting the shell of the core-shell quantum dot being different from each other.

The bandgap energy of the shell of the core-shell quantum dot is preferably 2.0 eV or more, more preferably 3.0 eV or more, still more preferably 4.0 eV or more, and preferably 5.0 eV or less, from the viewpoint of suppressing the heat deactivation of a carrier on the surface of the perovskite compound and improving the photoelectric conversion efficiency.

The shell of the core-shell quantum dot contains a compound which preferably has a lower end of the conduction band at a more negative energy level than the energy level of the lower end of the conduction band of the perovskite compound, and/or has an upper end of the valence band at a more positive energy level than the energy level of the upper end of the valence band of the perovskite compound, from the viewpoint of suppressing the heat deactivation of a carrier on the surface of the perovskite compound and improving the photoelectric conversion efficiency. From the above viewpoint, the compound has a lower end of the conduction band at a negative energy level of preferably 0.1 eV or more, more preferably 0.2 eV or more, still more preferably 0.3 eV or more, and preferably 2.0 eV or less, more preferably 1.0 eV or less, still more preferably 0.5 eV or less, with respect to the energy level of the lower end of the conduction band of the perovskite compound. In addition, from the above viewpoint, the compound has an upper end of the valence band at a positive energy level of preferably 0.1 eV or more, more preferably 0.5 eV or more, still more preferably 1.0 eV or more, and preferably 2.0 eV or less, more preferably 1.8 eV or less, still more preferably 1.5 eV or less, with respect to the energy level of the upper end of the valence band of the perovskite compound.

The average shell thickness of the core-shell quantum dots is preferably 0.1 nm or more, more preferably 0.3 nm or more, from the viewpoint of suppressing the heat deactivation of a carrier on the surface of the perovskite compound and improving the photoelectric conversion efficiency, and preferably 4 nm or less, more preferably 1 nm or less, still more preferably 0.6 nm or less, from the viewpoint of increasing the carrier diffusion length and improving the photoelectric conversion efficiency.

The average number of shell layers of the core-shell quantum dots is preferably 0.1 or more, more preferably 0.2 or more, still more preferably 1 or more, from the viewpoint of suppressing the heat deactivation of a carrier on the surface of the perovskite compound and improving the photoelectric conversion efficiency, and preferably 5 or less, more preferably 3 or less, still more preferably 2 or less, from the viewpoint of increasing the carrier diffusion length and improving the photoelectric conversion efficiency. As for the shell thickness and the number of shell layers of the core-shell quantum dot, the average thickness and the average number of layers can be determined by the method described in the Examples. The number of layers less than 1 means the ratio of the covering shell to the surface area of the core.

The atomic ratio of the metal element constituting the shell of the core-shell quantum dot to the metal element constituting the core thereof (shell/core) is preferably 0.1 or more, more preferably 1 or more, from the viewpoint of suppressing the heat deactivation of a carrier on the surface of the perovskite compound and improving the photoelectric conversion efficiency, and preferably 5 or less, more preferably 3 or less, still more preferably 2 or less, from the viewpoint of increasing the carrier diffusion length and improving the photoelectric conversion efficiency.

The mass ratio of the shell mass of the core-shell quantum dot to the core mass thereof (shell/core) is preferably 0.01 or more, more preferably 0.05 or more, still more preferably 0.1 or more, from the viewpoint of suppressing the heat deactivation of a carrier on the surface of the perovskite compound and improving the photoelectric conversion efficiency, and preferably 5 or less, more preferably 2 or less, still more preferably 1 or less, from the viewpoint of increasing the carrier diffusion length and improving the photoelectric conversion efficiency.

The particle size of the core-shell quantum dot is preferably 1 nm or more, more preferably 2 nm or more, still more preferably 3 nm or more, from the viewpoint of improving the stability and photoelectric conversion efficiency, and preferably 20 nm or less, more preferably 10 nm or less, still more preferably 5 nm or less, from the viewpoint of improving the film forming property and photoelectric conversion efficiency. The particle size of the core-shell quantum dot can be measured by a conventional method such as X-ray diffraction (XRD) crystallite size analysis and transmission electron microscope observation.

The method for manufacturing the core-shell quantum dots is not particularly limited, but examples thereof include a successive ionic layer adsorption and reaction (SILAR) method. Specifically, the core-shell quantum dots can be manufactured by alternately adding a solution containing cations of the compound constituting the shell and a solution containing anions of the compound constituting the shell into a solution containing the core. The circularity, shell thickness, and number of shell layers of the core-shell quantum dot can be adjusted within the desired range by appropriately adjusting the raw material composition, solvent, reaction temperature, reaction concentration, reaction time, raw material addition time, raw material addition timing, and the like.

The content ratio of the perovskite compound and the quantum dot in the light absorption layer is not particularly limited, but the content ratio (composite amount of quantum dots) of the quantum dot to the total content of the perovskite compound and the quantum dot is preferably 0.01% by mass or more, more preferably 0.05% by mass or more, still more preferably 0.10% by mass or more, even still more preferably 0.15% by mass or more, from the viewpoint of improving the durability and photoelectric conversion efficiency, and preferably 10% by mass or less, more preferably 8% by mass or less, still more preferably 6% by mass or less, from the viewpoint of improving the film formability and photoelectric conversion efficiency.

The content ratio between the perovskite compound and the "core" of the quantum dot in the light absorption layer is not particularly limited, but the content ratio of the "core" of the quantum dot to the total content of the perovskite compound and the quantum dots is preferably 0.01% by mass or more, more preferably 0.05% by mass or more, still more preferably 0.10% by mass or more, even more preferably 0.12% by mass or more, from the viewpoint of improving the durability and photoelectric conversion efficiency, and preferably 10% by mass or less, more preferably 8% by mass or less, still more preferably 6% by mass or less, from the viewpoint of improving the film forming property and photoelectric conversion efficiency.

The external quantum efficiency (EQE) of the light absorption layer at 500 nm results from the light absorption of the perovskite compound. The EQE of the light absorption layer at 500 nm is preferably 25% or more, more preferably 30% or more, still more preferably 40% or more, from the viewpoint of improving the photoelectric conversion efficiency.

The external quantum efficiency (EQE) of the light absorption layer at 500 nm may be lower than that of the perovskite compound alone which does not contain quantum dots. The ratio of the EQE of the light absorption layer to the EQE of the light absorption layer of the perovskite compound alone at 500 nm is preferably 0.5 or more, more preferably 0.7 or more, still more preferably 0.9 or more, from the viewpoint of improving the photoelectric conversion efficiency.

The thickness of the light absorption layer is not particularly limited, but is preferably 30 nm or more, more preferably 50 nm or more, still more preferably 80 nm or more, even still more preferably 100 nm or more, from the viewpoint of increasing light absorption to improve photoelectric conversion efficiency, and preferably 1000 nm or less, more preferably 800 nm or less, still more preferably 600 nm or less, even still more preferably 500 nm or less, from the same viewpoint. The thickness of the light absorption layer can be measured by a measuring method such as electron microscope observation of the cross section of the film.

The coverage of the light absorption layer to the porous layer is preferably 10% or more, more preferably 20% or more, still more preferably 30% or more, even still more preferably 40% or more, furthermore preferably 50% or more, from the viewpoint of improving the photoelectric conversion efficiency (current), and is 100% or less. The coverage of the light absorption layer to the porous layer can be measured by the method described in the following Examples.

From the viewpoint of improving the photoelectric conversion efficiency (voltage), the absorbance ratio (QD/P) of the quantum dot (QD) to the perovskite compound (P) in the light absorption layer is preferably 0.3 or less, more preferably 0.2 or less, still more preferably 0.1 or less, even still more preferably 0. The absorbance ratio (QD/P) in the light absorption layer is determined from the absorption spectrum of the light absorption layer measured by the method described in the following Example and is the ratio of the maximum absorbance of at least one kind of quantum dots to the absorbance of at least one kind of perovskite compounds. Here, the absorbance of at least one kind of quantum dot and the absorbance of at least one kind of perovskite compound are obtained respectively as the absorbance at the absorption peak position when they are measured independently.

The peak absorbance of the perovskite compound (P) in the light absorption layer is preferably 0.1 or more, more preferably 0.3 or more, still more preferably 0.5 or more, from the viewpoint of increasing the amount of light absorption and improving the photoelectric conversion efficiency, and preferably 2 or less, more preferably 1 or less, still more preferably 0.7 or less, from the viewpoint of improving the extraction efficiency of a photoexcited carrier and improving the photoelectric conversion efficiency.

The perovskite emission lifetime in the light absorption layer is preferably 1 ns or more, more preferably 1.5 ns or more, from the viewpoint of suppressing the heat deactivation of a carrier on the surface of the perovskite compound and improving the photoelectric conversion efficiency, and preferably 100 ns or less, more preferably 10 ns or less, still more preferably 6 ns or less, from the viewpoint of improving the two-step light absorption efficiency and improving the photoelectric conversion efficiency.

The crystallite diameter of the perovskite compound of the light absorption layer is preferably 10 nm or more, more preferably 20 nm or more, still more preferably 40 nm or more, from the viewpoint of improving the photoelectric conversion efficiency and is preferably 1000 nm or less from the same viewpoint. The crystallite diameter of the light absorption layer in the range of 100 nm or less can be measured by the method described in Examples below. Further, the crystallite diameter in the range exceeding 100 nm cannot be measured by the method described in Examples described later but does not exceed the thickness of the light absorption layer.

<Photoelectric Conversion Element>

The photoelectric conversion element of the present invention has the light absorption layer. In the photoelectric conversion element of the present invention, the configuration other than the light absorption layer is not particularly limited, and a configuration of a known photoelectric conversion element can be applied. In addition, the photoelectric conversion element of the present invention can be manufactured by a known method, except for the light absorption layer.

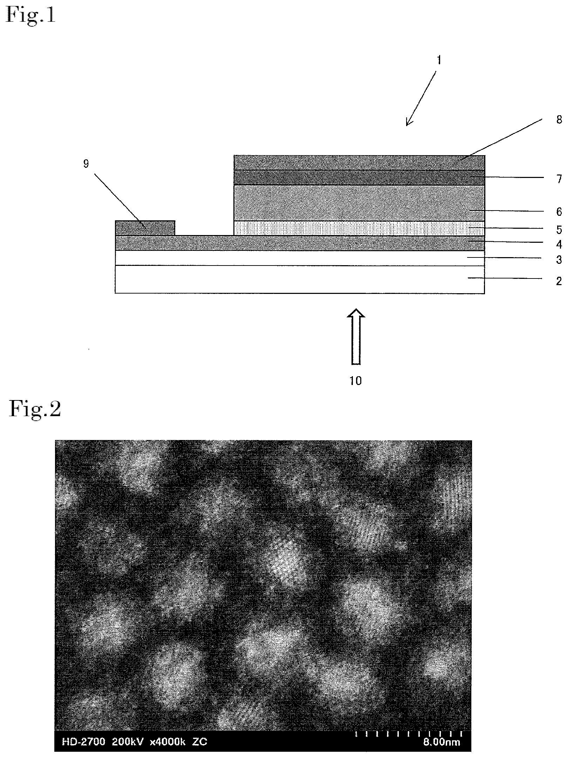

Hereinafter, the structure and manufacturing method of the photoelectric conversion element of the present invention will be described with reference to Fig. 1, but Fig. 1 is merely an example, and the present invention is not limited to the embodiment shown in Fig. 1.

Fig. 1 is a schematic sectional view showing an example of a structure of a photoelectric conversion element of the present invention. A photoelectric conversion element 1 has a structure in which a transparent substrate 2, a transparent conductive layer 3, a blocking layer 4, a porous layer 5, a light absorption layer 6, and a hole transport layer 7 are sequentially laminated. A transparent electrode substrate on the incident side of light 10 is composed of the transparent substrate 2 and the transparent conductive layer 3, and the transparent conductive layer 3 is bonded to an electrode (negative electrode) 9 which is a terminal for electrically connecting to an external circuit. In addition, the hole transport layer 7 is bonded to an electrode (positive electrode) 8 which serves as a terminal for electrically connecting to an external circuit.

As the material of the transparent substrate 2, any material may be used as long as it has strength, durability and light permeability, and synthetic resin and glass can be used for such a purpose. Examples of the synthetic resin include thermoplastic resins such as polyethylene naphthalate (PEN) film, polyethylene terephthalate (PET), polyester, polycarbonate, polyolefin, polyimide, and fluorine resin. From the viewpoints of strength, durability, cost and the like, it is preferable to use a glass substrate.

As the material of the transparent conductive layer 3, for example, indium-added tin oxide (ITO), fluorine-added tin oxide (FTO), tin oxide ($SnO_2$), indium zinc oxide (IZO), zinc oxide (ZnO), a polymer material having high conductivity and the like can be mentioned. Examples of the polymer material include polyacetylene type polymer materials, polypyrrole type polymer materials, polythiophene type polymer materials, and polyphenylenevinylene type polymer materials. As the material of the transparent conductive layer 3, a carbon-based thin film having high conductivity can also be used. Examples of a method for forming the transparent conductive layer 3 include a sputtering method, a vapor deposition method, a method of coating a dispersion, and the like.

Examples of the material of the blocking layer 4 include titanium oxide, aluminum oxide, silicon oxide, niobium oxide, tungsten oxide, tin oxide, zinc oxide, and the like. Examples of a method for forming the blocking layer 4 include a method of directly sputtering the above material on the transparent conductive layer 3 and a spray pyrolysis method. In addition, there is a method wherein a solution in which the above material is dissolved in a solvent or a solution in which a metal hydroxide that is a precursor of a metal oxide is dissolved is coated on the transparent conductive layer 3, dried, and baked as necessary. Examples of the coating method include gravure coating, bar coating, printing, spraying, spin coating, dipping, die coating, and the like.

The porous layer 5 is a layer having a function of supporting the light absorption layer 6 on its surface. In order to increase the light absorption efficiency in the solar cell, it is preferable to increase the surface area of the portion receiving light. By providing the porous layer 5, it is possible to increase the surface area of such a light-receiving portion.

Examples of the material of the porous layer 5 include a metal oxide, a metal chalcogenide (for example, a sulfide and a selenide), a compound having a perovskite type crystal structure (excluding the light absorber described above), a silicon oxide (for example, silicon dioxide and zeolite), and carbon nanotubes (including carbon nanowires and carbon nanorods), and the like.

Examples of the metal oxide include oxides of titanium, tin, zinc, tungsten, zirconium, hafnium, strontium, indium, cerium, yttrium, lanthanum, vanadium, niobium, aluminum, tantalum, and the like, and examples of the metal chalcogenide include zinc sulfide, zinc selenide, cadmium sulfide, cadmium selenide, and the like.

Examples of the compound having a perovskite type crystal structure include strontium titanate, calcium titanate, barium titanate, lead titanate, barium zirconate, barium stannate, lead zirconate, strontium zirconate, strontium tantalate, potassium niobate, bismuth ferrate, barium strontium titanate, barium lanthanum titanate, calcium titanate, sodium titanate, bismuth titanate, and the like.

The material for forming the porous layer 5 is preferably used as fine particles, more preferably as a dispersion containing fine particles. Examples of a method for forming the porous layer 5 include a wet method, a dry method, and other methods (for example, methods described in Chemical Review, Vol. 110, page 6595 (2010)). In these methods, it is preferable to coating the surface of the blocking layer 4 with a dispersion (paste), followed by baking. By baking, the fine particles can be brought into close contact with each other. Examples of coating methods include gravure coating method, bar coating method, printing method, spraying method, spin coating method, dipping method, die coating method, and the like.

The light absorption layer 6 is the above-described Light absorption layer of the present invention. A method of forming the light absorption layer 6 is not particularly limited, and, for example, there is preferably mentioned a method based on a so-called wet process in which a dispersion containing the perovskite compound or its precursor and the quantum dots is prepared and the prepared dispersion is coated on the surface of the porous layer 5, and is dried.

In the wet process, the dispersion containing the perovskite compound or its precursor and the quantum dots preferably contains a solvent in view of film-forming property, cost, storage stability, and excellent performance (for example, photoelectric conversion property). Examples of the solvent include esters (methyl formate, ethyl formate, etc.), ketones ($\gamma$-butyrolactone, N-methyl-2-pyrrolidone, acetone, dimethyl ketone, diisobutyl ketone, etc.), ethers (diethyl ether, methyl tert-butyl ether, dimethoxymethane, 1,4-dioxane, tetrahydrofuran, etc.), alcohols (methanol, ethanol, 2-propanol, tertbutanol, methoxypropanol, diacetone alcohol, cyclohexanol, 2-fluoroethanol, 2,2,2-trifluoroethanol, 2,2,3,3-tetrafluoro-1-propanol, etc.), glycol ethers (cellosolves), amide type solvents (N,N-dimethylformamide, acetamide, N,N-dimethylacetamide, etc.), nitrile type solvents (acetonitrile, isobutyronitrile, propionitrile, methoxyacetonitrile etc.), carbonate type solvents (ethylene carbonate, propylene carbonate, etc.), halogenated hydrocarbons (methylene chloride, dichloromethane, chloroform, etc.), hydrocarbons, dimethylsulfoxide, and the like.

The solvent of the dispersion is preferably a polar solvent, more preferably at least one solvent selected from ketones, amide type solvents, and dimethylsulfoxide (DMSO), still more preferably an amide type solvent, even still more preferably N,N-dimethylformamide from the viewpoints of film forming properties, cost, storage stability, and expression of excellent performance (for example, photoelectric conversion characteristics).

In view of film-forming property, cost, storage stability, and expression of excellent performance (for example, photoelectric conversion characteristics), the metal concentration of the perovskite compound or its precursor in the dispersion is preferably 0.1 mol/L or more, more preferably 0.2 mol/L or more, still more preferably 0.3 mol/L or more, and preferably 1.5 mol/L or less, more preferably 1.0 mol/L or less, still more preferably 0.5 mol/L or less.

From the viewpoints of film-forming property, cost, storage stability, and expression of excellent performance (for example, photoelectric conversion characteristics), the solid content concentration of the quantum dots in the dispersion is preferably 0.1 mg/mL or more, more preferably 0.5 mg/mL or more, still more preferably 1 mg/mL or more, and preferably 100 mg/mL or less, more preferably 50 mg/mL or less, still more preferably 30 mg/mL or less.

The preparation method of the dispersion is not particularly limited. The specific preparation method is as described in Examples.

The coating method in the wet process is not particularly limited, and examples thereof include gravure coating method, bar coating method, printing method, spraying method, spin coating method, dipping method, die coating method, and the like.

As a drying method in the wet process, for example, a thermal drying method, an air stream drying method, a vacuum drying method and the like can be mentioned, from the viewpoints of ease of production, cost, and expression of excellent performance (for example, photoelectric conversion characteristics), and the thermal drying is preferable.

As a material of the hole transport layer 7, there can be mentioned, for example, a carbazole derivative, a polyarylalkane derivative, a phenylenediamine derivative, an arylamine derivative, an amino-substituted chalcone derivative, a styrylanthracene derivative, a fluorene derivative, a hydrazone derivative, a stilbene derivative, a silazane derivative, an aromatic tertiary amine compound, a styrylamine compound, an aromatic dimethylidine-based compound, a porphyrin-based compound, a phthalocyaninebased compound, a polythiophene derivative, a polypyrrole derivative, a polyparaphenylene vinylene derivative, and the like. Examples of a method for forming the hole transport layer 7 include a coating method, a vacuum vapor deposition method and the like. Examples of the coating method include a gravure coating method, a bar coating method, a printing method, a spray method, a spin coating method, a dipping method, a die coating method, and the like.

As the material of the electrode (positive electrode) 8 and the electrode (negative electrode) 9, there can be mentioned, for example, metals such as aluminum, gold, silver and platinum; conductive metal oxides such as indium tin oxide (ITO), indium zinc oxide (IZO), and zinc oxide (ZnO); organic conductive materials such as conductive polymers; and carbon-based materials such as nanotubes. Examples of a method for forming the electrode (positive electrode) 8 and the electrode (negative electrode) 9 include a vacuum vapor deposition method, a sputtering method, a coating method, and the like.

\<Solar Cell\>

The solar cell of the present invention has the photoelectric conversion element. In the solar cell of the present invention, the configuration other than the light absorption layer is not particularly limited, and a known solar cell configuration can be applied. The solar cell of the present invention may be an intermediate-band solar cell.

The present invention and preferred embodiments of the present invention are described below.

\<1\>

A light absorption layer, comprising a perovskite compound and quantum dots, wherein the quantum dots have a circularity of 0.50 to 0.92.

\<2\>

A light absorption layer, comprising a perovskite compound, and quantum dots containing a compound which has a lower end of a conduction band at a more negative energy level than an energy level of a lower end of a conduction band of the perovskite compound, and/or has an upper end of a valence band at a more positive energy level than an energy level of an upper end of a valence band of the perovskite compound.

\<3\>

The light absorption layer according to \<1\> or \<2\>, wherein the band gap energy of the perovskite compound is preferably 1.5 eV or more, more preferably 2.0 eV or more, still more preferably 2.1 eV or more, even still more preferably 2.2 eV or more, and preferably 4.0 eV or less, more preferably 3.6 eV or less, still more preferably 3.0 eV or less, even still more preferably 2.4 eV or less.

\<4\>

The light absorption layer according to any one of \<1\> to \<3\>, wherein the energy level at the lower end of the conduction band of the perovskite compound is preferably 2.0 eV vs. vacuum or more, more preferably 3.0 eV vs. vacuum or more, still more preferably 3.3 eV vs. vacuum or more, and preferably 5.0 eV vs. vacuum or less, more preferably 4.0 eV vs. vacuum or less, still more preferably 3.5 eV. vs. vacuum or less.

\<5\>

The light absorption layer according to any one of \<1\> to \<4\>, wherein the energy level at the upper end of the valence band of the perovskite compound is preferably 4.0 eV vs. vacuum or more, more preferably 5.0 eV vs. vacuum or more, still more preferably 5.6 eV vs. vacuum or more, and preferably 7.0 eV vs. vacuum or less, more preferably 6.0 eV vs. vacuum or less, still more preferably 5.8 eV vs. vacuum or less.

\<6\>

The light absorption layer according to \<1\> or \<2\>, wherein

preferably, the band gap energy of the perovskite compound is 1.5 eV or more and 4.0 eV or less, the energy level at the lower end of the conduction band of the perovskite compound is 2.0 eV vs. vacuum or more and 5.0 eV vs. vacuum or less, and the energy level at the upper end of the valence band of the perovskite compound is 4.0 eV vs. vacuum or more and 7.0 eV vs. vacuum or less,
more preferably, the band gap energy of the perovskite compound is 2.0 eV or more and 3.6 eV or less, the energy level at the lower end of the conduction band of the perovskite compound is 3.0 eV vs. vacuum or more and 4.0 eV vs. vacuum or less, and the energy level at the upper end of the valence band of the perovskite compound is 5.0 eV vs. vacuum or more and 6.0 eV vs. vacuum or less,
still more preferably, the band gap energy of the perovskite compound is 2.1 eV or more and 3.0 eV or less, the energy level at the lower end of the conduction band of the perovskite compound is 3.3 eV vs. vacuum or more and 3.5 eV vs. vacuum or less, and the energy level at the upper end of the valence band of the perovskite compound is 5.6 eV vs. vacuum or more and 5.8 eV vs. vacuum or less,
even still more preferably, the band gap energy of the perovskite compound is 2.2 eV or more and 2.4 eV or less, the energy level at the lower end of the conduction band of the perovskite compound is 3.3 eV vs. vacuum or more and 3.5 eV vs. vacuum or less, and the energy level at the upper end of the valence band of the perovskite compound is 5.6 eV vs. vacuum or more and 5.8 eV vs. vacuum or less.

<7>

The light absorption layer according to any one of <1> to <6>, wherein the perovskite compound is preferably one or more kinds selected from a compound represented by the following general formula (1) and a compound represented by the following general formula (2), more preferably a compound represented by the following general formula (1):

$$RMX_3 \qquad (1)$$

wherein R is a monovalent cation, M is a divalent metal cation, and X is a halogen anion, and

$$R^1R^2R^3{}_{n-1}M_nX_{3n+1} \qquad (2)$$

wherein $R^1$, $R^2$ and $R^3$ are each independently a monovalent cation, M is a divalent metal cation, X is a halogen anion, and n is an integer of 1 to 10.

<8>

The light absorption layer according to <7>, wherein R is preferably one or more kinds selected from an alkyl ammonium ion and a formamidinium ion, more preferably one or more kinds selected from a monoalkylammonium ion and a formamidinium ion, still more preferably one or more kinds selected from a methylammonium ion, an ethylammonium ion, a butylammonium ion and a formamidinium ion, and even still more preferably a methylammonium ion.

<9>

The light absorption layer according to <7> or <8>, wherein $R^1$, $R^2$, and $R^3$ are each independently preferably one or more kinds selected from an alkyl ammonium ion and a formamidinium ion, more preferably a monoalkylammonium ion, still more preferably one or more kinds selected from a methylammonium ion, an ethylammonium ion, a butylammonium ion, a hexylammonium ion, an octylammonium ion, a decylammonium ion, a dodecyl ammonium ion, a tetradecyl ammonium ion, a hexadecyl ammonium ion, and an octadecyl ammonium ion.

<10>

The light absorption layer according to any one of <7> to <9>, wherein n is preferably 1 to 4.

<11>

The light absorption layer according to any one of <7> to <10>, wherein M is preferably $Pb^{2+}$, $Sn^{2+}$ or $Ge^{2+}$, more preferably $Pb^{2+}$ or $Sn^{2+}$, still more preferably $Pb^{2+}$.

<12>

The light absorption layer according to any one of <7> to <11>, wherein X is preferably a fluorine anion, a chlorine anion or a bromine anion, more preferably a chlorine anion or a bromine anion, still more preferably a bromine anion.

<13>

The light absorption layer according to <7>, wherein the compound represented by the general formula (1) is preferably $CH_3NH_3PbBr_3$ and/or $CH(=NH)NH_3PbBr_3$, more preferably $CH_3NH_3PbBr_3$.

<14>

The light absorption layer according to any one of <1> to <13>, wherein a crystallite diameter of the perovskite compound is preferably 10 nm or more, more preferably 20 nm or more, still more preferably 40 nm or more, and is preferably 1000 nm or less.

<15>

The light absorption layer according to any one of <1> to <14>, wherein the circularity of the quantum dots is preferably 0.60 or more, more preferably 0.65 or more, and preferably 0.90 or less, more preferably 0.80 or less.

<16>

The light absorption layer according to any one of <1> to <15>, wherein a band gap energy of the quantum dots is preferably 0.5 eV or more, more preferably 0.6 eV or more, still more preferably 0.7 eV or more, even still more preferably 0.8 eV or more, and preferably 1.0 eV or less, more preferably 0.95 eV or less, still more preferably 0.9 eV or less, even still more preferably 0.85 eV or less.

<17>

The light absorption layer according to any one of <1> to <16>, wherein a difference between a band gap energy of the perovskite compound and a band gap energy of the quantum dots is preferably 1.0 eV or more, more preferably 1.4 eV or more, still more preferably 1.45 eV or more, and preferably 2.0 eV or less, more preferably 1.7 eV or less, still more preferably 1.5 eV or less.

<18>

The light absorption layer according to any one of <1> to <17>, wherein an emission peak energy of the quantum dots is preferably 0.2 eV or more, more preferably 0.4 eV or more, still more preferably 0.6 eV or more, even more preferably 0.8 eV or more when the light absorption layer is excited with light having a wavelength of 800 nm (energy 1.55 eV), and preferably 1.4 eV or less, more preferably 1.2 eV or less, still more preferably 1.0 eV or less, even more preferably 0.95 eV or less.

<19>

The light absorption layer according to any one of <1> to <18>, wherein a difference between an emission peak energy of the quantum dots and a bandgap energy of the perovskite compound is preferably 0.4 eV or more, more preferably 0.8 eV or more, still more preferably 1.2 eV or more, even more preferably 1.4 eV or more, and preferably 3.4 eV or less, more preferably 2.5 eV or less, still more preferably 2.0 eV or less, even more preferably 1.5 eV or less.

<20>

The light absorption layer according to any one of <1> to <19>, wherein a difference between an emission peak energy of the quantum dots and a bandgap energy of the quantum dot is preferably 0.01 eV or more, more preferably 0.03 eV or more, still more preferably 0.05 eV or more, and preferably 0.3 eV or less, more preferably 0.2 eV or less, still more preferably 0.1 eV or less.

<21>

The light absorption layer according to any one of <1> to <20>, wherein a particle size of the quantum dots is preferably 1 nm or more, more preferably 2 nm or more, still more preferably 3 nm or more, and preferably 20 nm or less, more preferably 10 nm or less, still more preferably 5 nm or less.

<22>

The light absorption layer according to any one of <1> to <21>, wherein the quantum dots preferably contain Pb element, more preferably PbS or PbSe, still more preferably PbS.

<23>

The light absorption layer according to any one of <1> to <22>, wherein a metal constituting the perovskite compound and a metal constituting the quantum dots are the same metal.

<24>

The light absorption layer according to any one of <1> to <23>, wherein the quantum dots preferably contain one or more kinds selected from an organic ligand and a halogen element.

<25>

The light absorption layer according to <24>, wherein the organic ligand is preferably a carboxy group-containing compound or an amino group-containing compound, more preferably a carboxy group-containing compound, still more preferably a long chain fatty acid, even still more preferably oleic acid.

<26>

The light absorption layer according to any one of <1> to <25>, wherein a combination of the perovskite compound and the quantum dots is preferably a combination of compounds containing the same metal element, more preferably a combination of $CH_3NH_3PbBr_3$ and PbS.

<27>

The light absorption layer according to any one of <1> to <26>, wherein the quantum dots are core-shell quantum dots having a core-shell structure.

<28>

The light absorption layer according to <27>, wherein a compound constituting a core of the core-shell quantum dots preferably includes a Pb element, more preferably includes PbS or PbSe, still more preferably includes PbS.

<29>

The light absorption layer according to <27> or <28>, wherein a core of the core-shell quantum dots preferably includes a compound containing a metal element identical with a metal element constituting the perovskite compound.

<30>

The light absorption layer according to any one of <27> to <29>, wherein a particle size of a core of the core-shell quantum dots is preferably 1 nm or more, more preferably 2 nm or more, still more preferably 2.5 nm or more, and preferably 20 nm or less, more preferably 10 nm or less, still more preferably 5 nm or less.

<31>

The light absorption layer according to any one of <27> to <30>, wherein a bandgap energy of a core of the core-shell quantum dots is preferably 0.5 eV or more, more preferably 0.6 eV or more, still more preferably 0.7 eV or more, even more preferably 0.8 eV or more, and preferably 1.0 eV or less, more preferably 0.95 eV or less, still more preferably 0.9 eV or less, even more preferably 0.85 eV or less.

<32>

The light absorption layer according to any one of <27> to <31>, wherein a core of the core-shell quantum dots contains a compound which preferably has a lower end of the conduction band at a more positive energy level than the energy level of the lower end of the conduction band of the perovskite compound, and/or has an upper end of the valence band at a more negative energy level than the energy level of the upper end of the valence band of the perovskite compound.

<33>

The light absorption layer according to <32>, wherein the compound has a lower end of the conduction band at a positive energy level of preferably 0.1 eV or more, more preferably 0.3 eV or more, still more preferably 0.5 eV or more, and preferably 2.0 eV or less, more preferably 0.8 eV or less, still more preferably 0.65 eV or less, with respect to the energy level of the lower end of the conduction band of the perovskite compound.

<34>

The light absorption layer according to <32> or <33>, wherein the compound has an upper end of the valence band at a negative energy level of preferably 0.1 eV or more, more preferably 0.3 eV or more, and preferably 1.0 eV or less, more preferably 0.6 eV or less, with respect to the energy level of the upper end of the valence band of the perovskite compound.

<35>

The light absorption layer according to <32>, wherein

preferably, the compound has a lower end of the conduction band at a positive energy level of 0.1 eV or more and 2.0 eV or less, with respect to the energy level of the lower end of the conduction band of the perovskite compound, and the compound has an upper end of the valence band at a negative energy level of 0.1 eV or more and 1.0 eV or less, with respect to the energy level of the upper end of the valence band of the perovskite compound, more preferably, the compound has a lower end of the conduction band at a positive energy level of 0.3 eV or more and 0.8 eV or less, with respect to the energy level of the lower end of the conduction band of the perovskite compound, and the compound has an upper end of the valence band at a negative energy level of 0.3 eV or more and 0.6 eV or less, with respect to the energy level of the upper end of the valence band of the perovskite compound, still more preferably, the compound has a lower end of the conduction band at a positive energy level of 0.5 eV or more and 0.65 eV or less, with respect to the energy level of the lower end of the conduction band of the perovskite compound, and the compound has an upper end of the valence band at a negative energy level of 0.3 eV or more and 0.6 eV or less, with respect to the energy level of the upper end of the valence band of the perovskite compound.

<36>

The light absorption layer according to any one of <27> to <35>, wherein a compound constituting a shell of the core-shell quantum dots preferably includes a metal element different from a metal element constituting a core of the core-shell quantum dots, more preferably includes a Zn element, still more preferably includes ZnS and/or ZnSe, even more preferably includes ZnS.

<37>

The light absorption layer according to any one of <27> to <36>, wherein a shell of the core-shell quantum dots includes a compound containing a metal element different from a metal element constituting the perovskite compound.

<38>

The light absorption layer according to any one of <27> to <37>, wherein a bandgap energy of a shell of the core-shell quantum dots is preferably 2.0 eV or more, more preferably 3.0 eV or more, still more preferably 4.0 eV or more, and preferably 5.0 eV or less.

<39>

The light absorption layer according to any one of <27> to <38>, wherein a shell of the core-shell quantum dots contains a compound which has a lower end of the conduction band at a more negative energy level than the energy level of the lower end of the conduction band of the perovskite compound, and/or has an upper end of the valence band at a more positive energy level than the energy level of the upper end of the valence band of the perovskite compound.

<40>

The light absorption layer according to <39>, wherein the compound has a lower end of the conduction band at a negative energy level of preferably 0.1 eV or more, more preferably 0.2 eV or more, still more preferably 0.3 eV or more, and preferably 2.0 eV or less, more preferably 1.0 eV or less, still more preferably 0.5 eV or less, with respect to the energy level of the lower end of the conduction band of the perovskite compound.

<41>

The light absorption layer according to <39> or <40> wherein the compound has an upper end of the valence band at a positive energy level of preferably 0.1 eV or more, more preferably 0.5 eV or more, still more preferably 1.0 eV or more, and preferably 2.0 eV or less, more preferably 1.8 eV or less, still more preferably 1.5 eV or less, with respect to the energy level of the upper end of the valence band of the perovskite compound.

<42>

The light absorption layer according to <39>, wherein

preferably, the compound has a lower end of the conduction band at a negative energy level of 0.1 eV or more and 2.0 eV or less, with respect to the energy level of the lower end of the conduction band of the perovskite compound, and the compound has an upper end of the valence band at a positive energy level of 0.1 eV or more and 2.0 eV or less, with respect to the energy level of the upper end of the valence band of the perovskite compound, more preferably, the compound has a lower end of the conduction band at a negative energy level of 0.2 eV or more and 1.0 eV or less, with respect to the energy level of the lower end of the conduction band of the perovskite compound, and the compound has an upper end of the valence band at a positive energy level of 0.5 eV or more and 1.8 eV or less, with respect to the energy level of the upper end of the valence band of the perovskite compound, still more preferably, the compound has a lower end of the conduction band at a negative energy level of 0.3 eV or more and 0.5 eV or less, with respect to the energy level of the lower end of the conduction band of the perovskite compound, and the compound has an upper end of the valence band at a positive energy level of 1.0 eV or more and 1.5 eV or less, with respect to the energy level of the upper end of the valence band of the perovskite compound.

<43>

The light absorption layer according to any one of <27> to <31> and <36> to <38>, wherein

preferably, a compound contained in a core of the core-shell quantum dots has a lower end of the conduction band at a positive energy level of 0.1 eV or more and 2.0 eV or less, with respect to the energy level of the lower end of the conduction band of the perovskite compound, and has an upper end of the valence band at a negative energy level of 0.1 eV or more and 1.0 eV or less, with respect to the energy level of the upper end of the valence band of the perovskite compound, a compound contained in a shell of the core-shell quantum dots has a lower end of the conduction band at a negative energy level of 0.1 eV or more and 2.0 eV or less, with respect to the energy level of the lower end of the conduction band of the perovskite compound, and has an upper end of the valence band at a positive energy level of 0.1 eV or more and 2.0 eV or less, with respect to the energy level of the upper end of the valence band of the perovskite compound, more preferably, a compound contained in a core of the core-shell quantum dots has a lower end of the conduction band at a positive energy level of 0.3 eV or more and 0.8 eV or less, with respect to the energy level of the lower end of the conduction band of the perovskite compound, and has an upper end of the valence band at a negative energy level of 0.3 eV or more and 0.6 eV or less, with respect to the energy level of the upper end of the valence band of the perovskite compound, a compound contained in a shell of the core-shell quantum dots has a lower end of the conduction band at a negative energy level of 0.2 eV or more and 1.0 eV or less, with respect to the energy level of the lower end of the conduction band of the perovskite compound, and has an upper end of the valence band at a positive energy level of 0.5 eV or more and 1.8 eV or less, with respect to the energy level of the upper end of the valence band of the perovskite compound, still more preferably, a compound contained in a core of the core-shell quantum dots has a lower end of the conduction band at a positive energy level of 0.5 eV or more and 0.65 eV or less, with respect to the energy level of the lower end of the conduction band of the perovskite compound, and has an upper end of the valence band at a negative energy level of 0.3 eV or more and 0.6 eV or less, with respect to the energy level of the upper end of the valence band of the perovskite compound, a compound contained in a shell of the core-shell quantum dots has a lower end of the conduction band at a negative energy level of 0.3 eV or more and 0.5 eV or less, with respect to the energy level of the lower end of the conduction band of the perovskite compound, and has an upper end of the valence band at a positive energy level of 1.0 eV or more and 1.5 eV or less, with respect to the energy level of the upper end of the valence band of the perovskite compound.

<44>

The light absorption layer according to any one of <27> to <43>, wherein an average shell thickness of the core-shell quantum dots is preferably 0.1 nm or more, more preferably 0.3 nm or more, and preferably 4 nm or less, more preferably 1 nm or less, still more preferably 0.6 nm or less.

<45>

The light absorption layer according to any one of <27> to <44>, wherein an average number of shell layers of the core-shell quantum dots is preferably 0.1 or more, more preferably 0.2 or more, still more preferably 1 or more, and preferably 5 or less, more preferably 3 or less, still more preferably 2 or less.

<46>

The light absorption layer according to any one of <27> to <45>, wherein an atomic ratio of a metal element constituting a shell of the core-shell quantum dots to a metal element constituting a core thereof (shell/core) is preferably 0.1 or more, more preferably 1 or more, and preferably 5 or less, more preferably 3 or less, still more preferably 2 or less.

<47>

The light absorption layer according to any one of <27> to <46>, wherein a mass ratio of a shell mass of the core-shell quantum dots to a core mass thereof (shell/core) is preferably 0.01 or more, more preferably 0.05 or more, still more preferably 0.1 or more, and preferably 5 or less, more preferably 2 or less, still more preferably 1 or less.

<48>

The light absorption layer according to any one of <27> to <47>, wherein a particle size of the core-shell quantum dots is preferably 1 nm or more, more preferably 2 nm or more, still more preferably 3 nm or more, and preferably 20 nm or less, more preferably 10 nm or less, still more preferably 5 nm or less.

<49>

The light absorption layer according to any one of <1> to <48>, wherein a content ratio (composite amount of quantum dots) of the quantum dots to the total content of the perovskite compound and the quantum dots is preferably 0.01% by mass or more, more preferably 0.05% by mass or more, still more preferably 0.10% by mass or more, even still more preferably 0.15% by mass or more, and preferably 10% by mass or less, more preferably 8% by mass or less, still more preferably 6% by mass or less.

<50>

The light absorption layer according to any one of <27> to <49>, wherein a content ratio of a core of the quantum dots to the total content of the perovskite compound and the quantum dots is preferably 0.01% by mass or more, more preferably 0.05% by mass or more, still more preferably 0.10% by mass or more, even more preferably 0.12% by mass or more, and preferably 10% by mass or less, more preferably 8% by mass or less, still more preferably 6% by mass or less.

<51>

The light absorption layer according to any one of <1> to <50>, wherein an external quantum efficiency (EQE) of the light absorption layer at 500 nm is preferably 25% or more, more preferably 30% or more, still more preferably 40% or more.

<52>

The light absorption layer according to any one of <1> to <51>, wherein a ratio of an external quantum efficiency (EQE) of the light absorption layer to the EQE of the light absorption layer of the perovskite compound alone at 500 nm is preferably 0.5 or more, more preferably 0.7 or more, still more preferably 0.9 or more.

<53>

The light absorption layer according to any one of <1> to <52>, wherein a thickness of the light absorption layer is preferably 30 nm or more, more preferably 50 nm or more, still more preferably 80 nm or more, even still more preferably 100 nm or more, and preferably 1000 nm or less, more preferably 800 nm or less, still more preferably 600 nm or less, even still more preferably 500 nm or less.

<54>

The light absorption layer according to any one of <1> to <53>, wherein a coverage of the light absorption layer to a porous layer is preferably 10% or more, more preferably 20% or more, still more preferably 30% or more, even still more preferably 40% or more, furthermore preferably 50% or more, and is 100% or less.

<55>

The light absorption layer according to any one of <1> to <54>, wherein an absorbance ratio (QD/P) of the quantum dots (QD) to the perovskite compound (P) in the light absorption layer is preferably 0.3 or less, more preferably 0.2 or less, still more preferably 0.1 or less, even still more preferably 0.

<56>

The light absorption layer according to any one of <1> to <55>, wherein a peak absorbance of the perovskite compound (P) in the light absorption layer is preferably 0.1 or more, more preferably 0.3 or more, still more preferably 0.5 or more, and preferably 2 or less, more preferably 1 or less, still more preferably 0.7 or less.

<57>

The light absorption layer according to any one of <1> to <56>, wherein a perovskite emission lifetime in the light absorption layer is preferably 1 ns or more, more preferably 1.5 ns or more, and preferably 100 ns or less, more preferably 10 ns or less, still more preferably 6 ns or less.

<58>

A photoelectric conversion element having the light absorption layer according to any one of <1> to <57>.

<59>

A solar cell having the photoelectric conversion element according to <58>.

EXAMPLES

Hereinafter, the present invention will be described specifically based on Examples. Unless otherwise indicated in the table, the content of each component is % by mass. In addition, the evaluation/measurement method are as follows. In addition, unless otherwise noted, the experimentation and measurement were carried out at 25°C.

<I-V Curve>

Using an I-V characteristic measuring device (PECK 2400-N, manufactured by Peccell Technologies, Inc.) with a xenon-lamp white light as a light source (PEC-L01, manufactured by Peccell Technologies, Inc.) at a light intensity (100 mW/cm$^2$) equivalent to sunlight (AM 1.5) under a mask of light irradiation area 0.0363 cm$^2$ (2 mm square), an I-V curve of the cell was measured under the conditions of a scanning speed of 0.1 V/sec (0.01 V step), a waiting time of 50 msec after voltage setting, a measurement integration time of 50 msec, a starting voltage of -0.1 V, and an ending voltage of 1.1 V. The light intensity was corrected with a silicon reference (BS-520, 0.5714 mA). The short-circuit current density (mA/cm$^2$), open circuit voltage (V), fill factor (FF), and conversion efficiency (%) were determined from the I-V curve.

<External Quantum Efficiency>

An external quantum efficiency (EQE) spectrum is measured by a direct current method in a wavelength range of 300 to 1700 nm under a mask with a light irradiation area of 0.0363 cm$^2$ using a spectral response measurement system (CEP-2000 MLR manufactured by Bunkoukeiki Co., Ltd.). The EQE at a wavelength of 500 nm derived from the light absorption of the perovskite compound was determined. In addition, in the EQE of 500 nm derived from the light absorption of the perovskite compound, the ratio of the EQE of a quantum dot composite cell to the EQE of a perovskite single cell was calculated.

<Absorption Spectrum>

Using a UV-Vis spectrophotometer (SolidSpec-3700, manufactured by Shimadzu Corporation) under the conditions of a scanning speed of medium speed, a sample pitch of 1 nm, a slit width of 20, and an integrating sphere detector unit, the absorption spectrum of the light absorption layer was measured in the range of 300 to 1600 nm on a sample before applying the hole transport material. Background measurement was carried out with a fluorine-doped tin oxide (FTO) substrate (manufactured by Asahi Glass Fabritec Co., Ltd., 25 × 25 × 1.8 mm). The ratio of the absorbance of the quantum dot to the absorbance of the perovskite compound (QD/P) in the light absorption layer is a value obtained by dividing the absorbance of the peak wavelength of the quantum dot at around 1000 nm by the absorbance of the peak wavelength of the perovskite compound.

The absorption spectrum of the quantum dot dispersion was similarly measured in a toluene dispersion having a concentration of 0.1 mg/mL of quantum dot solid using a 1 cm square quartz cell.

Note that the absorption spectrum of the horizontal axis representing the wavelength $\lambda$ and the vertical axis representing the absorbance A was converted into the spectrum of the horizontal axis representing the energy hv and the vertical axis representing $(\alpha h v)^{1/2}$ ($\alpha$; absorption coefficient), and a straight line was fitted to the rising part of absorption and the intersection of the straight line and the baseline was taken as the band gap energy.

<Emission Spectrum>

Using a near-infrared fluorescence spectrometer (Fluorolog, manufactured by Horiba, Ltd.), the emission spectrum of the quantum dot dispersion was measured in the range of 850 to 1550 nm using a 1 cm square tetrahedral transparent cell in a toluene dispersion having a concentration of 0.1 mg/mL of quantum dot solid, under the conditions of an excitation wavelength of 800 nm, an excitation light slit-width of 10 nm, an emission slit width of 15 nm, an acquisition time of 0.1 sec, an average of two times integrations, and dark offset on.

The emission lifetime of the perovskite compound in a light absorption layer was measured in a light absorption layer produced in a similar way on a glass substrate, using an emission lifetime measuring device (manufactured by HORIBA, Ltd., Fluorolog-3, DeltaHub) under the conditions of semiconductor pulsed laser light source (manufactured by HORIBA, Ltd., delta diode DD-485L, excitation wavelength 478 nm), detection wavelength 540 nm, and measurement time range 0 to 100 ns. Prompt measurement was performed using filter paper, and three-component fitting was performed using analysis software (DAS6) to determine the lifetime $\tau$3.

<Film thickness and coverage of light absorption layer>

The film thickness and coverage of the light absorption layer were determined from SEM photographs of the cross section and the surface of the light absorption layer on a sample before being coated with the hole transport agent, using a field emission high-resolution scanning electron microscope (FE-SEM, manufactured by Hitachi, Ltd., S-4800). The coverage was calculated from the area ratio (area percentage) of the light absorption layer to the total area by specifying the light absorption layer with a pen tool using image analysis software (Winroof) on a SEM photograph of the surface (enlargement magnification: 20000 times).

<Crystallite size of perovskite compound>

The crystallite size of the perovskite compound in the light absorption layer was measured for the range of 5 to 60° using a powder X-ray diffractometer (manufactured by Rigaku Corporation, MiniFlex600, light source CuK$\alpha$, tube voltage 40 kV, tube current 15 mA) under the conditions of sampling width 0.02°, scanning speed 10°/min, solar slit (incident) 5.0°, divergence slit 1.250°, vertical divergence 13.0 mm, scattering slit 13.0 mm, solar slit (reflection) 5.0°, and a receiving slit 13.0 mm. The crystallite size of the perovskite compound was calculated at the strongest peak (2$\theta$ = 14°) of the perovskite compound using analysis software (PDXL, ver.2.6.1.2).

<Particle size and circularity of quantum dot >

The particle size of the quantum dot was determined by transmission electron microscope observation (TEM, manufactured by JEOL Ltd., JEM-2100). The circularity of the quantum dot was calculated from a Z-contrast image (enlargement magnification: 4000000 times) of the quantum dot photographed with a spherical aberration-corrected scanning transmission electron microscope (Cs-STEM, manufactured by Hitachi, Ltd., HD-2700) using image analysis software (Winroof). The circularity was calculated by the following formula and obtained as an average value of all particles (10 particles or more) in the Z contrast image.

$$\text{Circularity} = 4\pi S/L^2$$

S: Projected area
L: Peripheral length

<Composition of quantum dot>

The concentrations of Pb and Zn in the quantum dots were quantified by high frequency inductively coupled plasma emission spectroscopy (ICP) analysis after the quantum dots were completely dissolved in a nitric acid/hydrogen peroxide mixed solution. Assuming that the quantum dots are spheres with a single particle size, the densities of PbS and ZnS were 7.5 $g/cm^3$ and 4.1 $g/cm^3$, respectively, and one layer of ZnS had 0.31 nm, the core particle size of PbS, the shell thickness of ZnS, and the number of shell layers of ZnS were determined.

The concentration of oleic acid in the quantum dots was quantified by a proton ($^1$H) nuclear magnetic resonance (NMR) method using dibromomethane (manufactured by Wako Pure Chemical Industries, Ltd.) as an internal standard substance in a deuterated toluene (containing 99 atom% D, and TMS 0.03 vol%, manufactured by Sigma-Aldrich Japan K.K.). Measurement was carried out using an NMR apparatus (manufactured by Agilent Company, VNMRS400) under the conditions of resonance frequency 400 MHz, delay time 60 seconds, and 32 times-integration. The concentration of oleic acid in the quantum dots was determined from the ratio of the integral value of the vinyl proton of oleic acid (5.5 ppm vs. TMS) to the integral value of dibromomethane (3.9 ppm vs. TMS).

<Quantum dot>

Table 1 shows the composition and physical properties of quantum dots (manufactured by NNCrystal).

<Example 1>

The following steps (1) to (7) were carried out sequentially to prepare a cell.

(1) Etching and Cleaning of FTO Substrate

A part of a glass substrate with 25 mm square fluorine doped tin oxide (FTO) (manufactured by Asahi Glass Fabritec Corporation, 25 × 25 × 1.8 mm, hereinafter referred to as FTO substrate) was etched with Zn powder and a 2 mol/L hydrochloric acid aqueous solution. Ultrasonic cleaning was carried out for 10 minutes sequentially with 1 mass% neutral detergent, acetone, 2-propanol (IPA), and ion exchanged water.

(2) Ozone Cleaning

Ozone cleaning of the FTO substrate was performed immediately before the compact $TiO_2$ layer forming step. With the FTO side facing up, the substrate was placed in an ozone generator (ozone cleaner PC-450 UV, manufactured by Meiwafosis Co., Ltd.) and irradiated with UV for 30 minutes.

(3) Formation of Compact $TiO_2$ Layer (Blocking Layer)

Bis(2,4-pentanedionato)bis(2-propanolato) titanium (IV) (4.04 g, 75% IPA solution, manufactured by Tokyo Chemical Industry Co., Ltd.) was dissolved in 123.24 g of ethanol (anhydrous, manufactured by Wako Pure Chemical Industries) to prepare a spray solution. The spray solution was sprayed at a pressure of 0.3 MPa to an FTO substrate on a hot plate (450°C) from a height of about 30 cm. Spraying was repeated twice on the substrates of 20 cm × 8 rows to a spraying amount of about 7 g, and then the sprayed substrate was dried at 450°C for 3 minutes. This operation was repeated twice more to spray a total of about 21 g of the spray solution. Thereafter, the FTO substrate was immersed in an aqueous solution (50 mM) of titanium chloride (manufactured by Wako Pure Chemical Industries, Ltd.) and heated at 70°C for 30 minutes. After washing with water and drying, the FTO substrate was calcined at 500°C for 20 minutes (temperature rising: 15 minutes) to form a compact $TiO_2$ ($cTiO_2$) layer.

(4) Formation of Mesoporous $TiO_2$ Layer (Porous Layer)

Ethanol (1.41 g, anhydrous, manufactured by Wako Pure Chemical Industries, Ltd.) was added to 0.404 g of an anatase form $TiO_2$ paste (PST-18NR, manufactured by JGC Catalysts and Chemicals Ltd.) and the mixture was subjected to ultrasonic dispersion for 1 hour to obtain a $TiO_2$ coating liquid. In a dry room, the $TiO_2$ coating liquid was spin-coated (5000 rpm × 30 sec) on the $cTiO_2$ layer using a spin coater (MS-100, manufactured by Mikasa Co., Ltd.). After drying for 30 minutes on a hot plate at 125°C, the $cTiO_2$ layer was calcined at 500°C for 30 minutes (time for temperature rising: 60 minutes) to form a mesoporous $TiO_2$ ($mTiO_2$) layer.

(5) Formation of Light Absorption Layer

The light absorption layer and the hole transport layer were formed in a glove box. Lead bromide ($PbBr_2$, a precursor for perovskite, 0.228 g, manufactured by Tokyo Chemical Industry Co., Ltd.), 0.070 g of methylamine hydrobromide ($CH_3NH_3Br$, manufactured by Tokyo Chemical Industry Co., Ltd.), and 2 mL of DMF (anhydrous, manufactured by Wako Pure Chemical Industries, Ltd.) were mixed and stirred at room temperature to prepare a DMF solution (colorless transparent) of 0.31 mol/L perovskite ($CH_3NH_3PbBr_3$) raw material. A mixed dispersion (coating liquid) of quantum dots and a perovskite raw material was obtained by stirring and dispersing 0.003 g of dry solid of PbS quantum dots covered with 1.3 layers of a ZnS shell and the DMF solution of the perovskite raw material at room temperature for 30 minutes, followed by filtration through a PTFE filter with a pore size of 0.45 $\mu$m. The concentration of PbS in the coating liquid was calculated from the absorbance at 1000 nm of the DMF solvent-diluted dispersion of the coating liquid, and the mass ratio of PbS to the total content of PbS, ZnS and perovskite was calculated to be 0.12%.

The $mTiO_2$ layer was spin-coated with the coating liquid using a spin coater (MS-100, manufactured by Mikasa Corporation) (500 rpm × 5 sec, slope 5 sec, 1000 rpm × 40 sec, slope 5 sec, 3000 rpm × 50 sec). Twenty seconds after the start of the spin, 1 mL of toluene (dehydrated, manufactured by Wako Pure Chemical Industries, Ltd.), which was a poor solvent, was dropped at once to the center of the spin. Immediately after the spin coating, drying was performed on a 100°C hot plate for 10 minutes to form a light absorption layer. Production of a perovskite compound was confirmed by X-ray diffraction pattern, absorption spectrum and electron microscope observation.

(6) Formation of Hole Transport Layer

Bis(trifluoromethanesulfonyl)imide lithium (LiTFSI, 9.1 mg, manufactured by Wako Pure Chemical Industries, Ltd.), 8.7 mg of [tris(2-(1H-pyrazol-1-yl)-4-tert-butylpyridine) cobalt(III) tris(bis(trifluoromethylsulfonyl)imide)] (Co(4-tButylpyridyl-2-1H-pyrazole) 3.3 TFSI, manufactured by Wako Pure Chemical Industries, Ltd.), 72.3 mg of 2,2',7,7'-tetrakis[N,N-di-p-methoxyphenylamino]-9,9'-spirobifluorene (Spiro-OMeTAD, manufactured by Wako Pure Chemical Industries, Ltd.), 1 mL of chlorobenzene (manufactured by Nacalai Tesque), and 28.8 $\mu$L of tert-butylpyridine(TBP, manufactured by Sigma-Aldrich) were mixed and stirred at room temperature to prepare a hole transport material (HTM) solution (black-purple transparent). Immediately before use, the HTM solution was filtered through a PTFE filter with a pore size of 0.45 $\mu$m. The HTM solution was spin-coated (4000 rpm × 30 sec) on the light absorption layer using a spin coater (MS-100, manufactured by Mikasa Co., Ltd.). Immediately after spin coating, the spin-coated product was dried on a 70°C hot plate for 30 minutes. After drying, the contact part with FTO and the entire back surface of the substrate were wiped off with a cotton swab impregnated with $\gamma$-butyrolactone, further drying was performed on a hot plate at 70°C for several minutes, thereby forming a hole transport layer.

(7) Deposition of Gold Electrode

Gold was deposited to a thickness of 100 nm on the hole transport layer (vacuum deposition rate: 8 to 9 Å/sec) under vacuum (4 to 5 × 10$^{-3}$ Pa) using a vacuum vapor deposition apparatus (VTR-060M/ERH, manufactured by ULVAC KIKO Inc.) to form a gold electrode.

<Example 2>

In the formation of the light absorption layer in (5) of Example 1, a light absorption layer was formed in the same manner as in Example 1 to prepare a cell, except that PbS quantum dots covered with a 0.3 layer of a ZnS shell were used instead of PbS quantum dots covered with 1.3 layers of a ZnS shell.

<Comparative Example 1>

In the formation of the light absorption layer in (5) of Example 1, a light absorption layer was formed in the same manner as in Example 1 to prepare a cell, except that PbS quantum dots were used instead of PbS quantum dots covered with 1.3 layers of a ZnS shell.

[Table 1]

| | | | | Examples 1 | Examples 2 | Comparative Examples 1 |
|---|---|---|---|---|---|---|
| Perovskite (P) | Compound | | | $CH_3NH_3PbBr_3$ | $CH_3NH_3PbBr_3$ | $CH_3NH_3PbBr_3$ |
| | Lower end of conduction band | (eV vs. vacuum) | | 3.4 | 3.4 | 3.4 |
| | Upper end of valence band | (eV vs. vacuum) | | 5.7 | 5.7 | 5.7 |
| | Bandgap energy | (eV) | | 2.3 | 2.3 | 2.3 |
| Quantum dot (QD) | Core | Core compound | | PbS | PbS | PbS |
| | | Core particle size | (nm) | 2.9 | 3.7 | 3.9 |
| | | Lower end of conduction band of core compound | (eV vs. vacuum) | 4.0 | 4.1 | 4.2 |
| | | Upper end of valence band of core compound | (eV vs. vacuum) | 5.2 | 5.2 | 5.2 |
| | | Bandgap energy of core compound | (eV) | 0.83 | 0.89 | 1.0 |
| | Shell | Shell compound | | ZnS | ZnS | - |
| | | Lower end of conduction band of shell compound | (eV vs. vacuum) | 3.0 | 3.0 | - |
| | | Upper end of valence band of shell compound | (eV vs. vacuum) | 7.1 | 7.1 | - |
| | | Bandgap energy of shell compound | (eV) | 4.1 | 4.1 | - |
| | | Shell thickness | (nm) | 0.5 | 0.1 | - |
| | | Number of shell layers | | 1.3 | 0.3 | - |
| | Ratio of metal atoms (shell/ core) | (Atomic ratio) | | 1.4 | 0.2 | - |
| | Shell/core mass ratio | (Mass ratio) | | 0.58 | 0.08 | - |

(continued)

|  |  |  | Examples 1 | Examples 2 | Comparative Examples 1 |
|---|---|---|---|---|---|
|  | Total particle size (core + shell) | (nm) | 3.9 | 4.0 | 3.9 |
|  | Circularity | | 0.70 | 0.91 | 0.97 |
|  | Organic ligand | | Oleic acid | Oleic acid | Oleic acid |
|  | Organic ligand/core metal | (Molar ratio) | 1.2 | 0.2 | 0.4 |
|  | Bandgap energy | (eV) | 0.83 | 0.89 | 1.0 |
|  | Emission peak energy | (eV) | 0.89 | 1.0 | 1.0 |
| Light absorption layer | Compounded amount in terms of PbS | (Mass%) | 0.12 | 0.11 | 0.16 |
|  | Absorbance ratio (QD/P) | | 0 | 0 | 0 |
|  | Absorbance of perovskite | | 0.52 | 0.52 | 0.41 |
|  | Emission lifetime of perovskite | (ns) | 1.8 | 1.1 | 0.5 |
|  | Thickness | (nm) | 100 | 100 | 100 |
|  | Coverage | (%) | 89 | 75 | 73 |
|  | Crystallite size of perovskite | (nm) | 45 | 48 | 44 |
| Cell characteristics | Short-circuit current density | (mA/cm$^2$) | 3.6 | 3.3 | 2.2 |
|  | Open-circuit voltage | (V) | 0.78 | 0.54 | 0.50 |
|  | Fill factor | | 0.69 | 0.65 | 0.65 |
|  | Conversion efficiency | (%) | 2.0 | 1.2 | 0.7 |
|  | External quantum efficiency at 500 nm | (%) | 47 | 35 | 22 |
|  | Ratio of external quantum efficiency at 500 nm | (vs. Perovskite) | 1 | 0.74 | 0.47 |

From Table 1, it is apparent that the light absorption layers of Examples 1 and 2 in which PbS quantum dots surface-covered with a ZnS shell are compounded have longer emission lifetime, higher generation efficiency of electricity (external quantum yield of 500 nm) resulting from perovskite light absorption, and more excellent photoelectric conversion efficiency, compared to the light absorption layer of Comparative Example 1 in which PbS quantum dots are compounded.

INDUSTRIAL APPLICABILITY

The light absorption layer and the photoelectric conversion element of the present invention can be suitably used as a constituent member of a next generation solar cell.

DESCRIPTION OF REFERENCE SIGNS

1    Photoelectric conversion element
2    Transparent substrate
3    Transparent conductive layer
4    Blocking layer

5 Porous layer
6 Light absorption layer
7 Hole transport layer
8 Electrode (positive electrode)
9 Electrode (negative electrode)
10 Light

**Claims**

1. A light absorption layer, comprising a perovskite compound and quantum dots, wherein the quantum dots have a circularity of 0.50 to 0.92.

2. The light absorption layer according to claim 1, wherein the quantum dots have a core-shell structure.

3. The light absorption layer according to claim 2, wherein a shell of the quantum dots comprises a compound which has a lower end of a conduction band at a more negative energy level than an energy level of a lower end of a conduction band of the perovskite compound, and/or has an upper end of a valence band at a more positive energy level than an energy level of an upper end of a valence band of the perovskite compound.

4. The light absorption layer according to claim 2 or 3, wherein a core of the quantum dots comprises a compound which has a lower end of a conduction band at a more positive energy level than an energy level of a lower end of a conduction band of the perovskite compound, and/or has an upper end of a valence band at a more negative energy level than an energy level of an upper end of a valence band of the perovskite compound.

5. The light absorption layer according to any one of claims 2 to 4, wherein a shell of the quantum dots comprises a compound containing a metal element different from a metal element constituting the perovskite compound.

6. The light absorption layer according to any one of claims 2 to 5, wherein a core of the quantum dots comprises a compound containing a metal element identical with a metal element constituting the perovskite compound.

7. The light absorption layer according to any one of claims 1 to 6, wherein the perovskite compound is one or more kinds selected from a compound represented by the following general formula (1) and a compound represented by the following general formula (2):

$$RMX_3 \qquad (1)$$

wherein R is a monovalent cation, M is a divalent metal cation, and X is a halogen anion, and

$$R^1R^2R^3{}_{n-1}M_nX_{3n+1} \qquad (2)$$

wherein $R^1$, $R^2$ and $R^3$ are each independently a monovalent cation, M is a divalent metal cation, X is a halogen anion, and n is an integer of 1 to 10.

8. The light absorption layer according to claim 7, wherein X is a fluorine anion, a chlorine anion or a bromine anion.

9. The light absorption layer according to claim 7 or 8, wherein R, $R^1$, $R^2$ and $R^3$ are each independently an alkylammonium ion or a formamidinium ion.

10. The light absorption layer according to any one of claims 7 to 9, wherein M is $Pb^{2+}$, $Sn^{2+}$ or $Ge^{2+}$.

11. A light absorption layer, comprising a perovskite compound, and quantum dots containing a compound which has a lower end of a conduction band at a more negative energy level than an energy level of a lower end of a conduction band of the perovskite compound, and/or has an upper end of a valence band at a more positive energy level than an energy level of an upper end of a valence band of the perovskite compound.

12. The light absorption layer according to claim 11, wherein the quantum dots have a core-shell structure.

**13.** A photoelectric conversion element having the light absorption layer according to any one of claims 1 to 12.

**14.** A solar cell having the photoelectric conversion element according to claim 13.

Fig.1

Fig.2

HD-2700  200kV  x4000k  ZC                        8.00nm

**INTERNATIONAL SEARCH REPORT**

| International application No. |
|---|
| PCT/JP2018/042655 |

**A. CLASSIFICATION OF SUBJECT MATTER**
Int.Cl. H01L51/44(2006.01)i, H01L31/0352(2006.01)i

According to International Patent Classification (IPC) or to both national classification and IPC

**B. FIELDS SEARCHED**

Minimum documentation searched (classification system followed by classification symbols)
Int.Cl.        H01L31/02-31/078, H01L31/18-31/20, H01L51/42-51/48,
               H02S10/00-10/40, H02S30/00-99/00, B82Y40/00

Documentation searched other than minimum documentation to the extent that such documents are included in the fields searched
| | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)
Google Scholar

**C. DOCUMENTS CONSIDERED TO BE RELEVANT**

| Category* | Citation of document, with indication, where appropriate, of the relevant passages | Relevant to claim No. |
|---|---|---|
| X<br>A | SANCHEZ, R. S. et al., "Tunable light emission by exciplex state formation between hybrid halide perovskite and core/shell quantum dots: Implications in advanced LEDs and photovoltaics", Science Advances, 2016, vol. 2, no. 1, e1501104, pp. 1-7, Supplementray Materials | 11-14<br>1-10 |
| A | GALAR, P. et al., "Perovski te-quantum dots interface: Deciphering its ultrafast charge carrier dynamics", Nano Energy, July 2018, vol. 49, pp. 471-480 | 1-14 |

☒ Further documents are listed in the continuation of Box C.    ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 12 December 2018 (12.12.2018) | 25 December 2018 (25.12.2018) |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |
|---|---|

Form PCT/ISA/210 (second sheet) (January 2015)

**INTERNATIONAL SEARCH REPORT**

International application No.

PCT/JP2018/042655

C (Continuation). DOCUMENTS CONSIDERED TO BE RELEVANT

| Category* | Citation of document, with indication, where appropriate, of the relevant passages | Relevant to claim No. |
|---|---|---|
| A | JP 2016-122755 A (SHARP CORP.) 07 July 2016 (Family: none) | 1-14 |
| A | TAN, R. et al., "Probing Surface Saturation Conditions in Alternating Layer Growth of CdSe/CdS Core/Shell Quantum Dots", Chemistry of Materials, 2013, vol. 25, pp. 3724-3736 | 1-14 |
| A | WO 2018/163327 A1 (KAO CORP.) 13 September 2018 (Family: none) | 1-14 |
| A | WO 2018/163325 A1 (KAO CORP.) 13 September 2018 (Family: none) | 1-14 |
| A | CN 105047825 A (UNIV CHANGZHOU) 11 November 2015 (Family: none) | 1-14 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2018025445 A
- JP 6343406 B

**Non-patent literature cited in the description**

- *ACS Nano,* 2014, vol. 8, 614-622
- *J. Am. Chem. Soc.,* 2009, vol. 131, 6050-6051
- *ACS Nano,* 2014, vol. 8, 6363-6371
- *Chemical Review,* 2010, vol. 110, 6595